(19) **Europäisches Patentamt / European Patent Office / Office européen des brevets**

(11) **EP 1 595 432 B1**

(12) **EUROPÄISCHE PATENTSCHRIFT**

(45) Veröffentlichungstag und Bekanntmachung des Hinweises auf die Patenterteilung:
**19.12.2007 Patentblatt 2007/51**

(51) Int Cl.:
*H05K 1/02* (2006.01)    *H05K 9/00* (2006.01)

(21) Anmeldenummer: **03757697.2**

(22) Anmeldetag: **09.10.2003**

(86) Internationale Anmeldenummer:
**PCT/DE2003/003340**

(87) Internationale Veröffentlichungsnummer:
**WO 2004/073367 (26.08.2004 Gazette 2004/35)**

(54) **VORRICHTUNG UND VERFAHREN ZUR DÄMPFUNG VON HOHLRAUMRESONANZEN IN EINER MEHRSCHICHTIGEN TRÄGEREINRICHTUNG**

DEVICE AND METHOD FOR DAMPING CAVITY RESONANCE IN A MULTI-LAYER CARRIER MODULE

DISPOSITIF ET PROCEDE POUR ATTENUER DES RESONANCES DE CAVITE DANS UN ENSEMBLE SUPPORT MULTICOUCHE

(84) Benannte Vertragsstaaten:
**DE FR GB**

(30) Priorität: **11.02.2003 DE 10305520**

(43) Veröffentlichungstag der Anmeldung:
**16.11.2005 Patentblatt 2005/46**

(73) Patentinhaber: **ROBERT BOSCH GMBH**
**70442 Stuttgart (DE)**

(72) Erfinder: **NEIBIG, Uwe**
**71665 Vaihingen (DE)**

(56) Entgegenhaltungen:
| | |
|---|---|
| WO-A-02/41673 | US-A- 5 708 400 |
| US-A- 5 844 762 | US-A- 5 898 576 |
| US-A- 5 926 377 | US-A- 5 966 294 |
| US-A- 6 166 457 | US-B1- 6 198 362 |
| US-B1- 6 215 373 | US-B1- 6 418 031 |

EP 1 595 432 B1

**Beschreibung**

STAND DER TECHNIK

Die vorliegende Erfindung betrifft eine Vorrichtung und ein Verfahren zur Dämpfung von Hohlraumresonanzen in einer mehrschichtigen Trägereinrichtung und insbesondere in einer mehrschichtigen Leiterplatte oder einem mehrschichtigen μ-Hybriden.

Zur Verbesserung der elektromagnetischen Verträglichkeit (EMV) von gedruckten Schaltungen, welche insbesondere mit einer hohen Taktfrequenz betrieben werden, ist eine breitbandige, niederimpedante Gestaltung des Spannungsversorgungssystems von großer Bedeutung. Dies gilt insbesondere für Digitalschaltungen, in denen hohe und zukünftig weiter steigende Takt- und Signalfrequenzen mit kurzen Anstiegszeiten zu verarbeiten sind.

Eine übliche Realisierung zur Sicherstellung der elektromagnetischen Verträglichkeit besteht beispielsweise in der Ausbildung der Versorgungsspannungs- und der Bezugspotentialverdrahtung als durchgehende Ebenen bzw. Schichten, wie es sich bei mehrschichtigen Leiterplatten und μ-Hybriden anbietet. Zwischen diese Spannungsversorgungs- und Bezugspotentiallagen werden typischerweise zusätzlich sogenannte Abblockkondensatoren geschaltet, um auch im unteren Frequenzbereich eine niedrige Impedanz des Versorgungssystems zu erzielen.

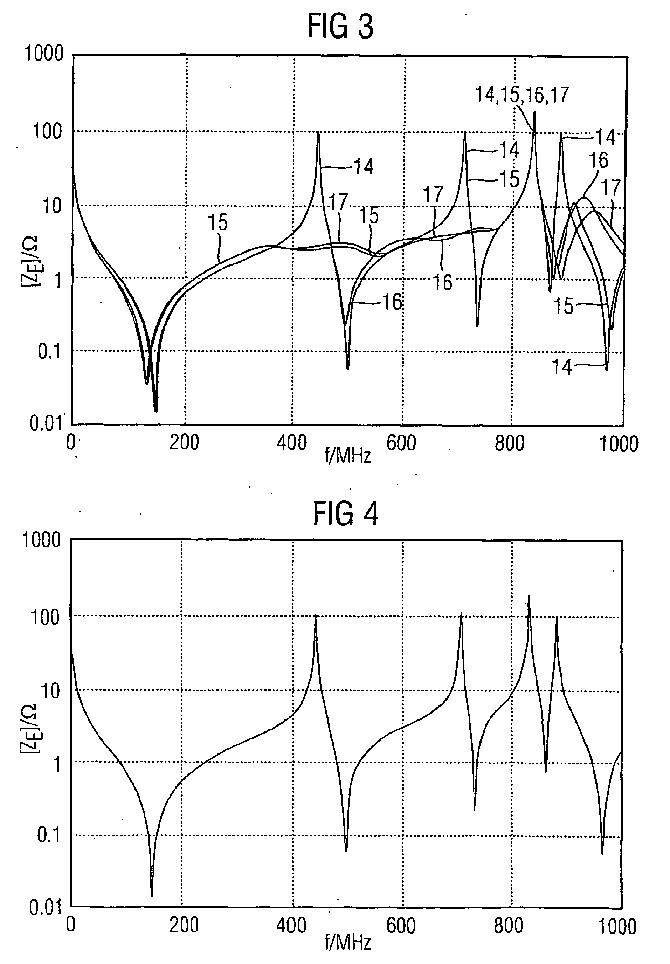

In Figur 4 ist der Betrag $|\underline{Z}_E|$ der Eingangsimpedanz über der Frequenz f in MHz aufgetragen, welche zwischen der durchgehenden Spannungsversorgungs- und Bezugspotentialschicht einer rechteckigen, zweilagigen 160 x 100 mm² großen Testleiterplatte mit einem 0,5 mm dicken Substrat dazwischen numerisch berechnet wurde. Messungen an realen Leiterplatten zeigen einen vergleichbaren Impedanzverlauf. Die Impedanz verhält sich näherungsweise wie die eines Serienschwingkreises. Im unteren Frequenzbereich, insbesondere unterhalb der Serienresonanzfrequenz von etwa 148 MHz, kann $|\underline{Z}_E|$ einfach reduziert werden, indem den beiden Schichten bzw. Lagen Abblockkondensatoren parallel geschaltet werden. Im oberen Frequenzbereich überlagern zahlreiche Parallel- und Serienresonanzen den Impedanzverlauf, die durch Reflexionen am Leiterplattenrand hervorgerufen werden. Sie können als Hohlraumresonanzen beschrieben werden, wobei sich die Hohlraumresonanz mit der niedrigsten Frequenz $f_{R.min}$ in einer rechteckigen Leiterplatte zu

$$f_{R.min} = \frac{c_0}{2 \cdot l \max \cdot \sqrt{\varepsilon_r}}$$

aus der größten Leiterplattenkantenlänge $1_{max}$ und der relativen Dielektrizitätszahl $\varepsilon_r$ des Leiterplattensubstrats bestimmen läßt. In der Testleiterplatte tritt die erste Hohlraumresonanz gemäß Figur 4 bei einer Frequenz von etwa 442 MHz auf, was gut mit dem gemäß obiger Gleichung unter Einsetzen von $\varepsilon_r$ = 4,5 analytisch berechneten Wert übereinstimmt.

Die hohen Impedanzen der Hohlraumresonanzen sind zu reduzieren, damit Takt- und Signalfrequenzen, welche mit den Parallelresonanzfrequenzen der Hohlraumresonanzen zusammenfallen, nicht die EMV der gedruckten Schaltung verschlechtern. Zur Dämpfung solcher Resonanzen sind zwei Verfahren bekannt, wobei das erste Verfahren gemäß Koch M.; Franz J.; John, W.: Theoretische und meßtechnische Bestimmung des Einflusses durchgehender Versorgungs- und Masselagen von Leiterplatten in Multilayertechnik auf die Abblockung, aus dem Tagungsband zum Kongreß "Elektromagnetische Verträglichkeit", Karlsruhe, 22.-24. Februar 1994, erschienen im VDE-Verlag, Berlin, 1994, auf den Seiten 511-520 auf dem Hochfrequenz-Abschluß des Leiterplattenrandes beruht. Durch den HF-Abschluß werden die Reflexionen vom Leiterplattenrand und damit die Resonanzen verringert. Um dies zu erreichen, ist der Leiterplattenrand mit der Impedanz abzuschließen, welche dem Feldwellenwiderstand des Leiterplattensubstrats entspricht. Ein solcher Abschluß führt jedoch zu einem sehr geringen Gleichstromwiderstand zwischen der Spannungsversorgungs- und der Bezugspotentialschicht, so daß eine Gleichspannungsabtrennung erforderlich ist.

Beim zweiten Verfahren zur Dämpfung der Hohlraumresonanzen werden gemäß der Veröffentlichung "Electromagnetic noise suppression for electronic cards and boards", IBM Technical Disclosure Bulletin, Bd. 33, Nr. 7, erschienen im Dezember 1990 auf den Seiten 243-246, XP000108425, New York, USA, die Hohlraumresonanzen durch eine Erhöhung der Verluste des Leiterplattensubstrats gedämpft. Dies kann gemäß der DE 198 02 243 in der Praxis mit Hilfe von Ferriten erfolgen, welche mit der Frequenz ansteigende magnetische Verluste generieren und beispielsweise in Pulverform dem als Substratmaterial dienenden Epoxidharz zugesetzt werden.

US-A-5 898 576 und US-B1-6 215 373 zeigen breitbandige Dämpfungslösungen.

VORTEILE DER ERFINDUNG

Die erfindungsgemäße Vorrichtung zur Dämpfung von Hohlraumresonanzen in einer mehrschichtigen Trägereinrichtung mit den Merkmalen des Anspruchs 1 und das erfindungsgemäße Verfahren zur Dämpfung von Hohlraumresonanzen in einer mehrschichtigen Trägereinrichtung mit den Merkmalen des Anspruchs 11 weisen gegenüber den bekannten Lösungsansätzen den Vorteil auf, daß Hohlraumresonanzen ohne einen Eingriff in die Herstellung der Leiterplatte wirksam unterdrückt werden. Auf diese Weise wird ein, insbesondere im Gegensatz zum ersten Verfahren, hoher Aufwand bei der Leiterplatten- bzw. μ-Hybrid-Fertigung vermieden, so daß gemäß der vorliegenden Erfindung eine kostengünstigere Möglichkeit zur Dämpfung von Hohlraumresonanzen bereitgestellt wird.

Die der vorliegenden Erfindung zugrunde liegende Idee besteht im wesentlichen darin, eine Dämpfung der Hohlraumresonanzen durch diskrete, verlustbehaftete Bauelemente vorzusehen, welche ähnlich bekannten Abblockkondensatoren zwischen die Spannungsversorgungs- und Bezugspotentialschicht geschaltet werden.

Mit anderen Worten wird zur Dämpfung von Hohlraumresonanzen in einer mehrschichtigen Trägereinrichtung eine erste leitfähige Einrichtung zum Bereitstellen einer Bezugspotentialschicht der Trägereinrichtung; eine zweite leitfähige Einrichtung elektrisch isoliert von der ersten leitfähigen Einrichtung zum Bereitstellen einer Spannungsversorgungsschicht der Trägereinrichtung; und mindestens eine diskrete, verlustbehaftete Schaltungskomponente vorgesehen, welche zwischen die erste und zweite leitfähige Einrichtung geschaltet und in Abhängigkeit von mindestens einer Hohlraumressonanz der Trägereinrichtung so dimensioniert ist, daß einen Schwingkreismit Resonanzfrequenz bei einer entsprechenden Hohbraumresonanzfrequenz gebildet wird.

In den Unteransprüchen finden sich vorteilhafte Weiterbildungen und Verbesserungen der im Anspruch 1 angegebenen Vorrichtung.

Gemäß einer bevorzugten Weiterbildung weist die diskrete, verlustbehaftete Schaltungskomponente eine vorbestimmte ohmsche und eine vorbestimmte kapazitive Komponente auf. Dies birgt den Vorteil einer Dimensionierung der Last, bei welcher keine Belastung bei einer Gleichspannung auftritt. Die Kapazität ist so zu wählen, daß sie mit der resultierenden parasitären Induktivität der diskreten, verlustbehafteten Schaltungskomponente einen Schwingkreis mit Resonanzfrequenz bei einer entsprechenden Hohlraumresonanzfrequenz bildet. Der Verlustwiderstand der diskreten, verlustbehafteten Schaltungskomponente ist so zu wählen, daß die Hohlraumresonanz möglichst optimal gedämpft wird.

Gemäß einer weiteren bevorzugten Weiterbildung ist die mindestens eine diskrete, verlustbehaftete Schaltungskomponente in einem vorbestimmten Bereich der Trägereinrichtung angeordnet. Dies birgt den Vorteil einer effizienten Lage der diskreten, verlustbehafteten Schaltungskomponente auf der Trägereinrichtung.

Gemäß einer weiteren bevorzugten Weiterbildung ist jeweils für eine Hohlraumresonanz der Trägereinrichtung eine separat in Abhängigkeit der jeweiligen Hohlraumresonanz dimensionierte, diskrete, verlustbehaftete Schaltungskomponente jeweils in einem vorbestimmten Bereich der Trägereinrichtung vorgesehen. Somit kann auf vorteilhafte Weise an verschiedenen Stellen der Trägereinrichtung eine jeweilige Hohlraumresonanz mit maximalem Erfolg gedämpft werden.

Gemäß einer weiteren bevorzugten Weiterbildung ist die mindestens eine diskrete, verlustbehaftete Schaltungskomponente im Bereich des Maximums der elektrischen Feldstärke einer Hohlraumresonanz angeordnet. Auf diese Weise ist eine maximale Effizienz in der Dämpfung einer Hohlraumresonanz gewährleistet.

Gemäß einer weiteren bevorzugten Weiterbildung ist bei einer rechteckigen Trägereinrichtung eine diskrete, verlustbehaftete Schaltungskomponente im Randbereich einer der kurzen Seiten zur Dämpfung einer vorzugsweise ersten Hohlraumresonanz angeordnet. Dabei ist von Vorteil, daß die erste Hohlraumresonanz optimal bedämpft werden kann.

Gemäß einer weiteren bevorzugten Weiterbildung ist bei einer rechteckigen Trägereinrichtung eine diskrete, verlustbehaftete Schaltungskomponente im Randbereich einer der langen Seiten zur Dämpfung einer, vorzugsweise zweiten, Hohlraumresonanz angeordnet. Durch diese vorteilhafte Lage wird die zweite Hohlraumresonanz bestmöglich bedämpft.

Gemäß einer weiteren bevorzugten Weiterbildung ist bei einer rechteckigen Trägereinrichtung eine diskrete, verlustbehaftete Schaltungskomponente in einem Eckbereich zur Dämpfung einer, vorzugsweise dritten, Hohlraumresonanz angeordnet. Durch diese Lage der verlustbehafteten Schaltungskomponente wird eine optimale Dämpfung der dritten Hohlraumresonanz gewährleistet.

Gemäß einer weiteren bevorzugten Weiterbildung ist die Trägereinrichtung eine mehrschichtige Leiterplatte oder ein mehrschichtiger μ-Hybrid zur Aufnahme von elektrischen Bauelementen.

ZEICHNUNGEN

Ein Ausführungsbeispiel der Erfindung ist in den Zeichnungen dargestellt und in der nachfolgenden Beschreibung näher erläutert.

Es zeigen:

Figur 1    eine schematische Draufsicht einer Bauelemente-Trägereinrichtung zur Erläuterung einer Ausführungsform der vorliegenden Erfindung;

Figur 2     eine schematische Querschnittsansicht einer Bauelemente-Trägereinrichtung vergrößert im Ausschnitt zur Erläuterung einer Ausführungsform der vorliegenden Erfindung;

Figur 3     eine schematische Frequenzgangsdarstellung zur Erläuterung der Funktionsweise einer Ausführungsform der vorliegenden Erfindung; und

Figur 4     eine schematische Darstellung eines Frequenzgangs einer üblichen Bauelemente-Trägereinrichtung.

BESCHREIBUNG DER AUSFÜHRUNGSBEISPIELE

In den Figuren bezeichnen gleiche Bezugszeichen gleiche oder funktionsgleiche Bestandteile.

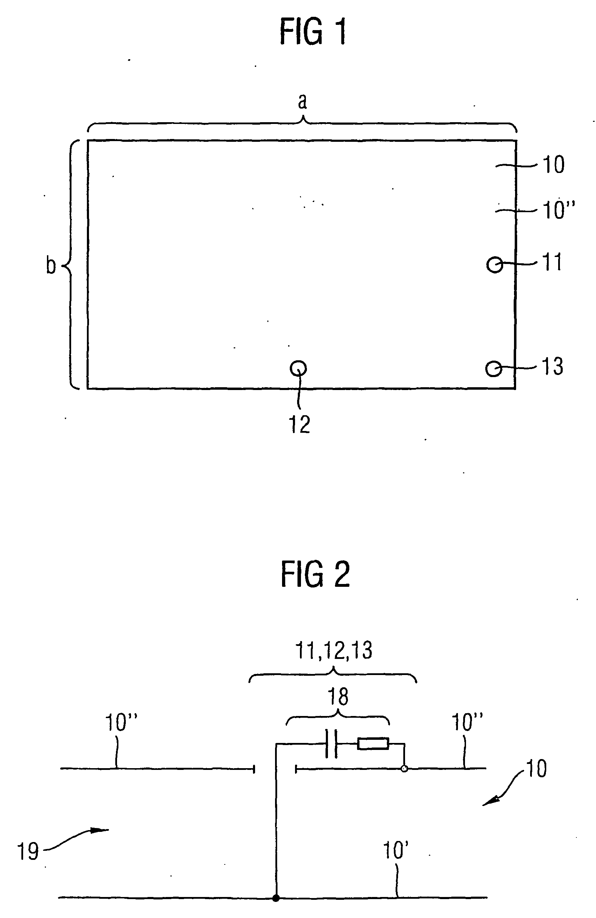

In Figur 1 ist eine mehrschichtige Trägereinrichtung 10, insbesondere eine mehrschichtige Leiterplatte oder ein mehrschichtiger μ-Hybrid in Draufsicht dargestellt. Die mehrschichtige Trägereinrichtung 10 weist eine erste elektrisch leitfähige Schicht zum Vorsehen eines Bezugspotentials (in Figur 1 nicht dargestellt) und davon elektrisch isoliert eine zweite im wesentlichen durchgängige elektrisch leitfähige Schicht 10" zum Vorsehen einer Versorgungsspannung auf. Als Isolationsmaterial (in Figur 1 nicht dargestellt) zwischen beiden leitfähigen Ebenen 10', 10" ist beispielsweise ein Epoxidharz vorgesehen. Abgesehen von diesen zwei durchgängigen Ebenen 10', 10", wobei die Spannungsversorgungs- und/oder Bezugspotentialschicht 10', 10" auch eine Teilfläche der Bauelemente-Trägereinrichtung 10 umfassen kann, kann die Bauelemente-Trägereinrichtung 10 beliebige weitere voneinander elektrisch isolierte Ebenen mit strukturierten Leiterbahnen aufweisen.

Mit Bezug auf Figur 1 und 2 können in vorbestimmten Bereichen 11, 12 und 13 gemäß der vorliegenden Erfindung zur Dämpfung von Hohlraumresonanzen, welche sich zwischen der Spannungsversorgungsebene 10" und der Bezugspotentialebene 10' ausbilden und zu Impedanzüberhöhungen führen können, diskrete, verlustbehaftete zweipolige Bauelemente bzw. Schaltungskomponenten 18 angeschlossen werden. Diese diskreten, verlustbehafteten Schaltungskomponenten 18 sind wie übliche Abblockkondensatoren zwischen die durchgehenden Versorgungsspannungs- und Bezugspotentiallagen 10', 10" der Trägereinrichtung 10, d.h. insbesondere einer Leiterplatte oder eines μ-Hybrids, geschaltet. Um einen maximal dämpfenden Einfluß aufzuweisen, wird eine diskrete, verlustbehaftete Schaltungskomponente 18 so platziert, daß sie sich im Bereich eines auftretenden Maximums der elektrischen Feldstärke einer entsprechenden Hohlraumresonanz befindet.

Zur Erzielung einer bestmöglichen Wirkung ist es daher im allgemeinen erforderlich, für jede zu dämpfende Hohlraumresonanz eine separate, und vorzugsweise auch separat dimensionierte, diskrete, verlustbehaftete Schaltungskomponente 18 vorzusehen. Am Beispiel einer rechteckigen Leiterplatte gemäß Figur 1 der Länge a und der Breite b mit a > b wird dies im nachfolgenden näher erläutert. Die erste Hohlraumresonanz mit der Resonanzfrequenz

$f_{R,1} = c_0/(2 \cdot a \cdot \sqrt{\varepsilon_r})$ (siehe obige Gleichung) weist gemäß dem Taschenbuch der Hochfrequenztechnik von Meinke, Gundlach, 4. Auflage, erschienen im Springer Verlag, Berlin Heidelberg New York Tokyo, 1986, gleichartige elektrische Feldstärkemaxima an den beiden kurzen Seiten a der Leiterplatte 10 auf. Dementsprechend ist die diskrete, verlustbehaftete Schaltungskomponente 18 im Randbereich 11 einer der kurzen Seiten der Länge b der Leiterplatte 10 zur Dämpfung der ersten Hohlraumresonanz etwa mittig anzuordnen und zwischen die Bezugspotential- und die Versorgungsspannungsschicht 10', 10'' zu schalten.

Die zweite Hohlraumresonanz mit der Resonanzfrequenz $f_{R,2} = c_0/(2 \cdot b \cdot \sqrt{\varepsilon_r})$ weist elektrische Feldstärkemaxima an den beiden langen Seiten der Länge a auf. Zu ihrer Dämpfung ist das diskrete, verlustbehaftete Bauelement 18 daher im Randbereich 12 einer der langen Seiten der Länge a etwa mittig entsprechend anzuschließen. Die dritte Hohlraumresonanz weist vier gleichartige Feldstärkenmaxima auf, welche sich in den Ecken 13.der Leiterplatte 10 befinden, so daß die diskrete, verlustbehaftete Schaltungskomponente 18 entsprechend in einer der Ecken 13 anzuordnen ist.

Einen Sonderfall stellt eine quadratische Leiterplatte (nicht dargestellt) dar, da hier die Resonanzfrequenzen der ersten und zweiten Hohlraumresonanz zusammenfallen und folglich identisch sind. Mit einer einzigen diskreten, verlustbehafteten Schaltungskomponente 18, welche in einer beliebigen Ecke 13 der quadratischen Leiterplatte angeordnet und zwischen die Bezugspotential- und die Versorgungsspannungsschicht 10', 10" geschaltet ist, lassen sich daher beide Hohlraumresonanzen wirksam dämpfen.

Im Gegensatz zu den Abblockkondensatoren (nicht dargestellt), die üblicherweise einen möglichst geringen ohmschen Verlustwiderstand aufweisen sollten, ist es erforderlich, daß die diskreten, verlustbehafteten Schaltungskomponenten 18 einen gewissen ohmschen Verlustwiderstand R aufweisen. Für jede Hohlraumresonanz und damit für jede diskrete, verlustbehaftete Schaltungskomponente 18 läßt sich ein Wert finden, der eine optimale Dämpfung der unerwünschten Impedanzüberhöhung bewirkt. Damit die diskreten, verlustbehafteten Schaltungskomponenten 18 bei Gleichspannung die Stromversorgung nicht unnötig belasten, ist eine Gleichspannungsabtrennung erforderlich.

Eine solche gleichspannungsmäßige Entkopplung läßt sich mit einem zu dem ohmschen Verlustwiderstand R in Reihe geschalteten Koppelkondensator C erreichen. Die zwischen der Bezugspotential- und Versorgungsspannungsschicht 10', 10" geschaltete diskrete, verlustbehaftete Schaltungskomponente 18 weist wie jedes zweipolige Bauelement eine unvermeidbare Gesamtinduktivität auf, welche sich aus der Bauelementinduktivität und der Anschlußinduktivität an die elektrisch leitfähigen Schichten bildet. Wird die Koppelkapazität C derart gewählt, daß sie mit der parasitären Gesamtinduktivität bei der Resonanzfrequenz einer Hohlraumresonanz in Serienresonanz kommt, wird der unerwünschte Einfluß der Induktivität eliminiert, so daß sich eine optimale Dämpfung erzielen läßt. Diese Optimierung der Kapazität des Koppelkondensators C ist deshalb möglich, weil vorzugsweise für jede Hohlraumresonanz eine separate diskrete, verlustbehaftete Schaltungskomponente eingesetzt wird. In der praktischen Realisierung kann die diskrete, verlustbehaftete Schaltungskomponente 18 aus einem verlustbehafteten Kondensator C mit entsprechend dimensionierter Kapazität bestehen.

In Figur 3 sind berechnete Frequenzgänge der Eingangsimpedanz $|\underline{Z}_E|$ einer 160 x 100 mm$^2$ großen Testlei-terplatte mit entsprechend optimierten Lasten dargestellt. Die Kurve 14 verdeutlicht den Frequenzgang ohne diskrete, verlustbehaftete Schaltungskomponente. Das Schaubild 15 zeigt den Frequenzgang mit einem diskreten, verlustbehafteten Bauelement zur Dämpfung der ersten Hohlraumresonanz. Das Schaubild 16 zeigt den Frequenzgang mit einem diskreten, verlustbehafteten Bauelement zur Dämpfung der zweiten Hohlraumresonanz. Und Schaubild 17 verdeutlicht den Frequenzgang mit zwei diskreten, verlustbehafteten Bauelementen zur Dämpfung der ersten und zweiten Hohlraumresonanz.

In Figur 3 ist die Auswirkung von rechnerisch optimierten diskreten, verlustbehafteten Schaltungskomponenten 18 zur Dämpfung der ersten zwei Hohlraumresonanzen in der obigen Testleiterplatte dargestellt. Es ist der numerisch berechnete Frequenzgang von $|\underline{Z}_E|$ ohne verlustbehaftete Bauelemente, mit einem verlustbehafteten Bauelement am rechten Leiterplattenrand 11, mit einem verlustbehafteten Bauelement am unteren Leiterplattenrand 12 und mit diesen beiden verlustbehafteten Bauelementen dargestellt.

Bei einer willkürlich angenommenen Bauelementinduktivität von 0,5 nH liefert die Optimierung für die erste Last eine Kapazität von 150 pF und einen Widerstand von 1,5 Ω. Für die zweite Last ergeben sich Werte von 50 pF und 2,0 Ω. Die Hohlraumresonanzen werden dadurch deutlich abgesenkt. Beispielsweise wird die erste Hohlraumresonanz mit einem Maximum von $|\underline{Z}_E|$ = 98 Ω auf einen Wert von 2,7 Ω gedämpft. Um dieses gleiche Verhältnis, welches 31,2 dB entspricht, wird dementsprechend auch die Störspannung abgesenkt, welche Takt- oder Signalströme in diesem Frequenzbereich verursachen. Darüber hinaus geht aus Figur 3 hervor, daß sich die einzelnen optimierten diskreten, verlustbehafteten Schaltungskomponenten 18 bzw. Bauelemente in der Kombination nicht behindern, d.h. keinen nachteiligen Einfluß aufeinander ausüben. Bei den gewählten Leiterplattenabmessungen, welche typisch für zahlreiche elektronische Geräte sind, läßt sich mit nur zwei diskreten, verlustbehafteten Schaltungskomponenten 18 bereits ein Frequenzbereich mit geringer Impedanz erzielen, der den praktischen Erfordernissen nachkommt.

Die Wirksamkeit der Dämpfung von Hohlraumresonanzen läßt sich direkt mit einer hochfrequenten Impedanzmessung zwischen der Spannungsversorgungs- und der Bezugspotentialschicht 10', 10" einer Leiterplatte 10 nachweisen. Außerdem ist sie anhand einer verminderten Störspannung auf dem Spannungsversorgungssystem an den Hohlraumresonanzfrequenzen nachweisbar.

Obwohl die vorliegende Erfindung vorstehend anhand eines bevorzugten Ausführungsbeispiels beschrieben wurde, ist sie darauf nicht beschränkt, sondern auf vielfältige Weise modifizierbar.

So kann die Erfindung bei allen elektronischen Geräten eingesetzt werden, welche auf mehrlagigen Bauelemente-Trägereinrichtungen, d.h. insbesondere Leiterplatten oder μ-Hybriden, realisiert sind und jeweils eine durchgehende Spannungsversorgungs- und Bezugspotentialschicht bzw. -lage besitzen, wobei die Spannungsversorgungs- und/oder Bezugspotentialschicht auch eine Teilfläche der Leiterplattenfläche umfassen kann. Sie ist bei Schaltungen sinnvoll, deren Takt- und Signalfrequenzen im Frequenzbereich der auftretenden Hohlraumresonanzen einen störenden Anteil aufweisen.

Da keine Modifikationen an der Leiterplatte selbst notwendig sind, sondern lediglich die diskreten, verlustbehafteten Schaltungskomponenten 18 zu bestücken sind, kann die Erfindung prinzipiell auch nachträglich eingebaut werden. Sollten als Last wirkende, verlustbehaftete Kondensatoren nicht hinreichend preisgünstig verfügbar sein, kann die diskrete, verlustbehaftete Schaltungskomponente 18 bzw. Last auch als Serienschaltung aus einem Standard-Widerstand R und einem Standard- Kondensator C gebildet werden.

Als kostengünstigste Variante bietet sich an, eine einzige geeignet plazierte diskrete, verlustbehaftete Schaltungskomponente 18 einzusetzen, mit welcher sich die ersten drei Hohlraumresonanzen dämpfen lassen, welches für viele Leiterplattenanwendungen in der Praxis ausreichend ist. Die entsprechenden drei Hohlraumresonanzen lassen sich damit zwar nicht so weit dämpfen wie mit einzeln optimierten und separat platzierten Lasten gemäß Figur 1 und Figur 3, die Dämpfung der ersten drei Hohlraumresonanzen beträgt jedoch immer noch etwa 20 dB, was bereits eine beträchtliche Verbesserung der elektromagnetischen Beeinflussung einer Leiterplatte darstellt.

Somit wird eine wirksame Dämpfung von Hohlraumresonanzen bei geringem zusätzlichen Aufwand an kostengünstigen Bauelementen bei leichter Integration in bestehende Konzepte ohne gravierenden Eingriff in die Herstellung einer Bauelemente-Trägereinrichtung bzw. einer Leiterplatte gewährleistet.

Vorrichtung und Verfahren zur Dämpfung von Hohlraumresonanzen in einer mehrschichtigen Trägereinrichtung

BEZUGSZEICHENLISTE

| 10 | Mehrschichtige Trägereinrichtung, z.B. Leiterplatte |
|---|---|
| 10' | leitfähige Einrichtung, z.B. Bezugspotentialebene |
| 10'' | leitfähige Einrichtung, z.B. Spannungsversorgüngsebene |
| 11 | Anschlußbereich einer diskreten, verlustbehafteten Schaltungskomponente zwischen einer Spannungsversorgungs- und einer Bezugspotentialschicht der Trägereinrichtung |
| 12 | Anschlußbereich einer diskreten, verlustbehafteten Schaltungskomponente zwischen einer Spannungsversorgungs- und einer Bezugspotentialschicht der Trägereinrichtung |
| 13 | Anschlußbereich einer diskreten, verlustbehafteten Schaltungskomponente zwischen einer Spannungsversorgungs- und einer Bezugspotentialschicht der Trägereinrichtung |
| 14 | Frequenzgang ohne diskretes, verlustbehaftetes Bauelement |
| 15 | Frequenzgang mit diskretem, verlustbehafteten Bauelement (zur Dämpfung der ersten Hohlraumresonanz) |
| 16 | Frequenzgang mit diskretem, verlustbehafteten Bauelement (zur Dämpfung der zweiten Hohlraumresonanz) |
| 17 | Frequenzgang mit diskreten, verlustbehafteten Bauelementen (zur Dämpfung der ersten und zweiten Hohlraumresonanz) |
| 18 | verlustbehaftete Schaltungskomponente, z.B. Kondensator in Reihe zu einem ohmschen Widerstand |
| 19 | elektrische Isolation, z.B. aus Epoxidharz |
| R | Ohmscher Widerstand |
| C | Kondensator |
| a, b | Seitenlängen |

**Patentansprüche**

1. Vorrichtung zur Dämpfung von Hohlraumresonanzen in einer mehrschichtigen Trägereinrichtung (10) mit:

   einer ersten leitfähigen Einrichtung (10') zum Bereitstellen einer Bezugspotentialschicht der Trägereinrichtung (10);
   einer zweiten leitfähigen Einrichtung (10'') elektrisch isoliert von der ersten leitfähigen Einrichtung (10') zum Bereitstellen einer Spannungsversorgungsschicht der Trägereinrichtung (10); und
   mindestens einer diskreten, verlustbehafteten Schaltungskomponente (18), welche zwischen die erste und zweite leitfähige Einrichtung (10', 10'') geschaltet und in Abhängigkeit von mindestens einer Hohlraumresonanz der Trägereinrichtung (10) so dimensioniert ist, daß ein Schwingkreis mit Resonanzfrequenz bei einer Hohhraumresonanzfrequenz der Trägereinrichtung gebildet wird.

2. Vorrichtung nach Anspruch 1,
   **dadurch gekennzeichnet,**
   **daß** die diskrete, verlustbehaftete Schaltungskomponente (18) eine vorbestimmte ohmsche und eine vorbestimmte kapazitive Komponente aufweist.

3. Vorrichtung nach Anspruch 1 oder 2,
   **dadurch gekennzeichnet,**
   **daß** die diskrete, verlustbehaftete Schaltungskomponente (18) aus einem mit ohmschen Verlusten behafteten Koppelkondensator oder aus einer Reihenschaltung aus einem Koppelkondensator und einem ohmschen Widerstand besteht.

4. Vorrichtung nach einem der vorangehenden Ansprüche,
   **dadurch gekennzeichnet,**
   **daß** die mindestens eine diskrete, verlustbehaftete Schaltungskomponente (18) in einem vorbestimmten Bereich (11, 12, 13) der Trägereinrichtung (10) angeordnet ist.

5. Vorrichtung nach Anspruch 4,
   **dadurch gekennzeichnet,**
   **daß** jeweils für eine Hohlraumresonanz der Trägereinrichtung (10) eine separat in Abhängigkeit der jeweiligen Hohlraumresonanz dimensionierte, diskrete, verlustbehaftete Schaltüngskomponente jeweils in einem vorbestimmten Bereich (11, 12, 13) der Trägereinrichtung (10) vorgesehen ist.

6. Vorrichtung nach Anspruch 4 oder 5,
   **dadurch gekennzeichnet,**
   **daß** die mindestens eine diskrete, verlustbehaftete Schaltungskomponente (18) im Bereich des Maximums der elektrischen Feldstärke einer Hohlraumresonanz angeordnet ist.

7. Vorrichtung nach Anspruch 5 oder 6,
   **dadurch gekennzeichnet,**
   **daß** bei einer rechteckigen Trägereinrichtung (10) eine diskrete, verlustbehaftete Schaltungskomponente (18) im Randbereich (11) einer der kurzen Seiten (b) zur Dämpfung einer, vorzugsweise ersten, Hohlraumresonanz angeordnet ist.

8. Vorrichtung nach Anspruch 6 oder 7,
   **dadurch gekennzeichnet,**
   **daß** bei einer rechteckigen Trägereinrichtung (10) eine diskrete, verlustbehaftete Schaltungskomponente (18) im Randbereich (12) einer der langen Seiten (a) zur Dämpfung einer, vorzugsweise zweiten, Hohlraumresonanz angeordnet ist.

9. Vorrichtung nach Anspruch 6, 7 oder 8,
   **dadurch gekennzeichnet,**
   **daß** bei einer rechteckigen Trägereinrichtung (10) eine diskrete, verlustbehaftete Schaltungskoinponente (18) in einem Eckbereich (13) zur Dämpfung einer, vorzugsweise dritten, Hohlraumresonanz angeordnet ist.

10. Vorrichtung nach einem der vorangehenden Ansprüche,
    **dadurch gekennzeichnet,**
    **daß** die Trägereinrichtung (10) eine mehrschichtige Leiterplatte oder ein mehrschichtiger $\mu$-Hybrid zur Aufnahme von elektrischen Bauelementen ist.

11. Verfahren zur Dämpfung von Hohlraumresonanzen in einer mehrschichtigen Trägereinrichtung (10) mit den Schritten:

    Bereitstellen einer Bezugspotentiaischicht durch eine erste leitfähige Einrichtung (10') der Trägereinrichtung (10);
    Bereitstellen einer Spannungsversbigungsschicht durch eine zweite leitfähige Einrichtung (10") eiel-trisch isoliert von der ersten leitfähigen Einrichtung (10') der Trägereinrichtung (10);
    Schalten mindestens einer diskreten, verlustbehafteten Schaltungskomponente (18) zwischen die erste und zweite leitfähige Einrichtung (10', 10"); und
    Dimensionieren der diskreten, verlustbehafteten Schaltungskomponente (18) in Abhängigkeit von mindestens einer Hohlraumresonanz der Trägereinrichtung (10) derart, daß ein Schwingkreis mit Resonanzfrequenz bei einer entsprechenden Hohlraumresonanzfrequenz der Trägereinrichtung gebildet wird.

**Claims**

1. Apparatus for damping cavity resonances in a multilayer mounting device (10), having:

a first conductive device (10') for providing a reference-earth potential layer for the mounting device (10);
a second conductive device (10"), electrically isolated from the first conductive device (10'), for providing a voltage supply layer for the mounting device (10); and
at least one discrete, lossy circuit component (18) which is connected between the first and the second conductive device (10', 10") and is designed as a function of at least one cavity resonance of the mounting device (10) such that a resonant circuit is formed with a resonant frequency at a cavity resonant frequency of the mounting device.

**2.** Apparatus according to Claim 1,
**characterized in that**
the discrete, lossy circuit component (18) has a predetermined resistive component and a predetermined capacitive component.

**3.** Apparatus according to Claim 1 or 2,
**characterized in that**
the discrete, lossy circuit component (18) comprises a coupling capacitor with resistive losses, or a coupling capacitor and a non-reactive resistor connected in series.

**4.** Apparatus according to one of the preceding claims,
**characterized in that**
the at least one discrete, lossy circuit component (18) is arranged in a predetermined area (11, 12, 13) of the mounting device (10).

**5.** Apparatus according to Claim 4,
**characterized in that**
a discrete, lossy circuit component which is designed separately as a function of the respective cavity resonance is in each case provided in a predetermined area (11, 12, 13) of the mounting device (10) for each cavity resonance of the mounting device (10).

**6.** Apparatus according to Claim 4 or 5,
**characterized in that**
the at least one discrete, lossy circuit component (18) is arranged in the area of the maximum electrical field strength of a cavity resonance.

**7.** Apparatus according to Claim 5 or 6,
**characterized in that**
if the mounting device (10) is rectangular, a discrete, lossy circuit component (18) is arranged in the edge area (11) of one of the short sides (b) in order to damp one, preferably first, cavity resonance.

**8.** Apparatus according to Claim 6 or 7,
**characterized in that**
if the mounting device (10) is rectangular, a discrete, lossy circuit component (18) is arranged in the edge area (12) of one of the long sides (a) in order to damp one, preferably second, cavity resonance.

**9.** Apparatus according to Claim 6, 7 or 8,
**characterized in that**
if the mounting device (10) is rectangular, a discrete, lossy circuit component (18) is arranged in a corner area (13), in order to damp one, preferably third, cavity resonance.

**10.** Apparatus according to one of the preceding claims,
**characterized in that**
the mounting device (10) is a multilayer printed circuit board or a multilayer μ-hybrid for holding electrical components.

**11.** Method for damping cavity resonances in a multilayer mounting device (10), having the following steps:

a reference-earth potential layer is provided by a first conductive device (10') of the mounting device (10);
a voltage supply layer is provided by a second conductive device (10"), electrically isolated from the first conductive device (10') of the mounting device (10);

at least one discrete, lossy circuit component (18) is connected between the first and the second conductive device (10', 10"); and

the discrete, lossy circuit component (18) is designed as a function of at least one cavity resonance of the mounting device (10), such that a resonant circuit is formed with a resonant frequency at a corresponding cavity resonant frequency of the mounting device.

**Revendications**

1. Dispositif pour amortir des résonances de cavité dans une installation de support 10 multicouche comprenant :

   - une première installation conductrice 10' fournissant une couche de potentiel de référence de l'installation de support 10,
   - une seconde installation conductrice 10" isolée électriquement de la première installation conductrice 10' pour fournir une couche d'alimentation en tension de l'installation de support 10, et
   - au moins un composant de commutation 18 discret, sujet aux pertes, branché entre la première et la seconde installation conductrice 10', 10" et qui est dimensionné en fonction d'au moins une résonance de cavité de l'installation de support 10 pour former un circuit résonant dont la fréquence de résonance est la fréquence de résonance de la cavité de l'installation porteuse.

2. Dispositif selon la revendication 1,
   **caractérisé en ce que**
   le composant de commutation 18 discret, sujet aux pertes, a un composant ohmique prédéfini et un composant capacitif prédéfini.

3. Dispositif selon l'une quelconque des revendications 1 ou 2,
   **caractérisé en ce que**
   le composant de commutation 18, discret, sujet aux pertes, se compose d'un condensateur de couplage sujet à des pertes ohmiques ou un montage en série d'un condensateur de couplage et d'une résistance ohmique.

4. Dispositif selon l'une quelconque des revendications précédentes,
   **caractérisé en ce qu'**
   au moins un composant de commutation 18, discret, sujet aux pertes, est prévu dans une zone prédéfinie 11, 12, 13 de l'installation de support 10.

5. Dispositif selon la revendication 4,
   **caractérisé en ce que**
   pour chaque résonance de cavité de l'installation de support 10, il est prévu un composant de commutation discret, sujet aux pertes, distinct, dimensionné suivant la résonance respective de la cavité, dans une plage prédéfinie 11, 12, 13 de l'installation de support 10.

6. Dispositif selon l'une quelconque des revendications 4 ou 5,
   **caractérisé en ce qu'**
   au moins un composant de commutation 18 discret, sujet aux pertes est prévu au niveau du maximum de l'intensité du champ électrique d'une résonance de cavité.

7. Dispositif selon l'une quelconque des revendications 5 ou 6,
   **caractérisé en ce que**
   pour une installation de support rectangulaire 10, un composant de commutation 18, discret, sujet aux pertes, est prévu dans la zone marginale 11 d'un côté court (b) pour amortir une résonance de cavité de préférence une première résonance.

8. Dispositif selon l'une quelconque des revendications 6 ou 7,
   **caractérisé en ce que**
   pour l'installation de support 10 rectangulaire, un composant de commutation 18, discret, sujet aux pertes est prévu dans la zone marginale 12 d'un côté long (a) pour amortir une résonance de cavité de préférence une seconde résonance de cavité.

9. Dispositif selon l'une quelconque des revendications 6, 7 ou 8,
   **caractérisé en ce que**
   pour une installation de support rectangulaire 10, un composant de commutation 18, discret, sujet aux pertes, est prévu dans une zone de coin 13 pour amortir une résonance de cavité de préférence une troisième résonance.

10. Dispositif selon l'une quelconque des revendications précédentes,
    **caractérisé en ce que**
    l'installation de support 10 est une plaque conductrice multicouche ou un hybride ($\mu$), multicouche pour recevoir des composants électriques.

11. Procédé d'amortissement des résonances de cavité dans une installation de support 10 multicouche comprenant les étapes suivantes :

    - développement d'une couche de potentiel de référence par une première installation conductrice 10' de l'installation de support 10,
    - le développement d'une couche d'alimentation en tension par une seconde installation conductrice 10", isolée électriquement de la première installation conductrice 10' de l'installation de support 10,
    - commutation d'au moins un composant de commutation 18, discret, sujet aux pertes, entre la première et la seconde installation conductrice 10', 10", et
    - dimensionnement de composant de commutation 18, discret, sujet aux pertes, en fonction d'au moins une résonance de cavité de l'installation de support 10 de façon à former un circuit oscillant dont la fréquence de résonance correspond à la fréquence de résonance de cavité de l'installation de support.

## FIG 1

## FIG 2

# FIG 3

# FIG 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19802243
- US 5898576 A
- US 6215373 B1


**In der Beschreibung aufgeführte Nicht-Patentliteratur**

- **KOCH M. ; FRANZ J. ; JOHN, W.** Theoretische und meßtechnische Bestimmung des Einflusses durchgehender Versorgungs- und Masselagen von Leiterplatten in Multilayertechnik auf die Abblockung. *Tagungsband zum Kongreß ''Elektromagnetische Verträglichkeit,* 22. Februar 1994, 511-520
- Electromagnetic noise suppression for electronic cards and boards. *IBM Technical Disclosure Bulletin,* Dezember 1990, vol. 33 (7), 243-246